**Europäisches Patentamt**

**European Patent Office**

**Office européen des brevets**

(11) Veröffentlichungsnummer: **0 421 016 A1**

## (12) EUROPÄISCHE PATENTANMELDUNG

(21) Anmeldenummer: 89118610.8

(22) Anmeldetag: 06.10.89

(51) Int. Cl.5: **H03K 19/018, H03K 3/2885**

(43) Veröffentlichungstag der Anmeldung:
**10.04.91 Patentblatt 91/15**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Impler Strasse 23**
**W-8000 München(DE)**

(54) **ECL-TTL-Signalpegelwandler.**

(57) ECL-TTL-Signalpegelwandler mit einem durch ECL-Signale gesteuerten ersten Transistorpaar (T1, T2) an dessen Kollektoren über jeweils einen Kollektorwiderstand (R1, R2) ein erstes Versorgungspotential (VCC) und an dessen gekoppelte Emitter über eine gemeinsame Stromeinprägung (R3) ein zweites Versorgungspotential (VEE) angelegt ist, und mit einer an die Kollektoren des ersten Transistorpaares (T1, T2) angeschlossenen Gegentaktausgangsstufe (T3, T4, R13) zur Ausgabe eines TTL-Signals, mit einem zwischen das erste Transistorpaar (T1, T2) und die Kollektorwiderstände (R1, R2) geschalteten zweiten Transistorpaar (T15, T16), an dessen gekoppelten Basen ein Bezugspotential (GND) angelegt ist, dessen Kollektoren jeweils mit einem der Kollektorwiderstände (R1, R2) und dessen Emitter jeweils mit einem der Kollektoren des ersten Transistorpaares (T1, T2) verbunden sind, mit einem emittergekoppelten dritten Transistorpaar (T11, T12), bei dem die Basis eines Transistors (T11) und der Kollektor des anderen Transistors (T12) mit dem Kollektor eines Transistors (T2) des ersten Transistorpaares (T1, T2) verbunden sind und bei dem der Kollektor des einen Transistors (T11) und die Basis des anderen Transistors (T12) mit dem Kollektor des anderen Transistors (T1) des ersten Transistorpaares (T1, T2) verbunden sind und mit einem zwischen erstes Transistorpaar (T1, T2) und Stromeinprägung (T5, R3) geschalteten, durch Steuersignale (C, C̄) gesteuerten vierten Transistorpaar (T13, T14) bei dem die gekoppelten Emitter mit der Stromeinprägung (T5, R3) verbunden sind und bei dem der Kollektor eines Transistors (T13) an die gekoppelten Emitter des ersten Transistorpaares (T1, T2) und der Kollektor des anderen Transistors (T14) an die gekoppelten Emitter des dritten Transistorpaares (T11, T12) angeschlossen sind.

EP 0 421 016 A1

**DIE ERFINDUNG BETRIFFT EINEN ECL-TTL-SIGNALPEGELWANDLER NACH DEM OBERBEGRIFF DES PATENTANSPRUCHES 1.**

ECL-TTL-Signalpegelwandler haben die Aufgabe, aus ECL-Schaltnetzen stammende Signale mit dem dafür charakteristischen Signalhub in Signale zur Steuerung von TTL-Schaltnetzen mit einem anderen typischen Signalhub umzuformen. Wichtig ist hierbei aber noch, daß in ECL-Schaltnetzen in der Regel ein negatives Versorgungspotential, während für TTL-Schaltnetze ein positives Versorgungspotential gegenüber einem Bezugspotential notwendig ist. Ein solcher ECL-TTL-Wandler ist beispielsweise aus der DE-PS 32 43 706 bekannt.

Neben den unterschiedlichen Signalpegeln weisen ECL-Signale und TTL-Signale häufig auch voneinander unterschiedliche zeitliche Strukturen auf. Zur Anpassung der Signale aneinander werden dem ECL-TTL-Signalpegelwandler daher üblicherweise zusätzlich ein Speicherelement in ECL-Technik vorgeschaltet und/oder ein Speicherelement in TTL-Technik nachgeschaltet.

Der Erfindung liegt die Aufgabe zugrunde, einen ECL-TTL-Signalpegelwandler mit Speicherfunktion anzugeben.

Diese Aufgabe wird bei einem gattungsgemäßen ECL-TTL-Signalpegelwandler durch die kennzeichnenden Merkmale des Patentanspruches 1 gelöst. Ausgestaltungen und Weiterbildungen des Erfindungsgedankens sind in Unteransprüchen gekennzeichnet.

Vorteile der Erfindung sind der geringe schaltungstechnische Aufwand und damit der geringe Platzbedarf bei Integration, die geringe Leistungsaufnahme sowie kürzere Laufzeit gegenüber den bisherigen Lösungen.

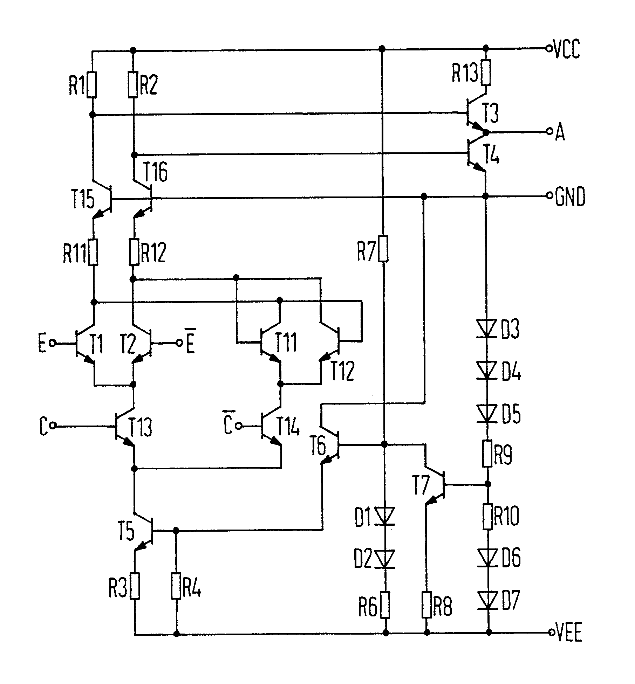

Die Erfindung wird nachfolgend anhand des in der einzigen Figur der Zeichnung dargestellten Ausführungsbeispiels näher erläutert.

Das Ausführungsbeispiel zeigt einen ECL-TTL-Signalpegelwandler, der wie der bekannte Wandler gemäß DE-PS 32 43 706 ein durch ein ECL-Signal $E,\overline{E}$ gesteuertes erstes Transistorpaar mit einem Transistor T1 und einem Transistor T2 enthält, an deren Kollektoren über jeweils einen Kollektorwiderstand R1,R2 ein positives Versorgungspotential VCC und an deren gekoppelten Emittern über eine gemeinsame Stromeinprägung T5,R3 ein negatives Versorgungspotential VEE angelegt ist. Zur Ausgabe eines TTL-Signales A ist ebenfalls eine Gegentakt-Ausgangsstufe mit einem Transistor T3, mit einem Transistor T4 sowie mit einem Widerstand R13 vorgesehen. Der Kollektor des Transistors T3 ist über den Widerstand R13 mit dem positiven Versorgungspotential VCC und der Emitter des Transistors T4 ist mit einem Bezugspotential GND beaufschlagt. Der Emitter des Transistors T3 und der Kollektor des Transistors T4 sind miteinander verbunden und führen das TTL-Signal A. Die Basis des Transistors T3 ist mit dem Kollektorzweig des Transistors T1 und die Basis des Transistors T4 mit dem Kollektorzweig des Transistors T2 gekoppelt.

Erfindungsgemäß weist das Ausführungsbeispiel darüber hinaus ein zwischen das erste Transistorpaar mit den Transistoren T1,T2 und die Kollektorwiderstände R1,R2 geschaltetes zweites Transistorpaar mit einem Transistor T15 und einem Transistor T16 auf. Die Kollektoren der Transistoren T15 und T16 sind dabei jeweils mit einem der Kollektorwiderstände R1 und R2 und dessen Emitter jeweils mit dem Kollektor eines der Transistoren T1 und T2 verbunden. Die gekoppelten Basen der Transistoren T15 und T16 sind mit dem Bezugspotential GND beaufschlagt. Des weiteren ist ein emittergekoppeltes drittes Transistorpaar mit einem Transistor T11 und mit einem Transistor T12 vorgesehen, wobei die Basis des Transistors T11 und der Kollektor des Transistors T12 an den Kollektor des Transistors T2 sowie der Kollektor des Transistors T11 und die Basis des Transistors T12 an den Kollektor des Transistors T1 angeschlossen sind. Schließlich weist das Ausführungsbeispiel erfindungsgemäß noch ein zwischen erstes Transistorpaar und Stromeinprägung geschaltetes durch Steuersignale $C,\overline{C}$ gesteuertes viertes Transistorpaar mit einem Transistor T13 und mit einem Transistor T14 auf, deren gekoppelte Emitter mit der Stromeinprägung verbunden sind und bei denen jeweils der Kollektor eines der Transistoren T13 und T14 mit den gekoppelten Emittern der Transistoren T1 und T2 bzw. mit den gekoppelten Emittern der Transistoren T11 und T12 verschaltet ist.

In Ausgestaltung der Erfindung sind den Emittern des zweiten Transistorpaares mit den Transistoren T15,T16 Emitterwiderstände R11 und R12 vorgeschaltet. Dadurch wird eine Stabilisierung des Arbeitspunktes von erstem Transistorpaar mit den Transistoren T1, T2 bzw. von dem dritten Transistorpaar mit den Transistoren T11, T12 erzielt.

Die Erfindung weiterbildend ist als Stromeinprägung ein erster Transistor T5 vorgesehen, dessen Kollektor mit den gekoppelten Emittern des vierten Transistorpaares mit den Transistoren T13, T14 verbunden ist, an dessen Emitter und Basis über einen ersten bzw. zweiten Widerstand R3,R4 das zweite Versorgungspotential VEE angelegt ist und dessen Basis mit dem Emitter eines kollektorseitig mit dem Bezugspotential GND beaufschlagten zweiten Transistors T6 verschaltet ist. An die Basis des zweiten Transistors T6 ist darüber hinaus über einen dritten Widerstand R7 das erste Versorgungspotential VCC und zum einen über zwei Dioden D1,D2 und einen vierten Widerstand R6 in Reihe und zum anderen über die Kollektor-Emitter-Strecke eines dritten Transistors T7 und einen fünften Widerstand R8 in Reihe das zweite Versorgungspotential VEE angelegt. An die Basis des dritten Transistors T7 ist über eine Serienschaltung aus drei Dioden D3,D4,D5 und einem sechsten Widerstand R9 das Bezugspotential GND und über eine Serienschaltung von zwei Dioden D6,D7 und einem siebten Widerstand R10 das zweite versorgungspotential VEE angelegt. Die Widerstandswerte sind dabei so gewählt, daß das Produkt aus dem dritten Widerstand R7 und dem siebten Widerstand R10 gleich dem Produkt aus dem fünften Widerstand R8 und aus der Summe des sechsten und siebten Widerstandes R9,R10 ist. Der Vorteil dabei ist, daß der zur Speisung des ersten Transistorpaares mit den Transistoren T1,T2 vorgesehene Strom von Temperatur- und Versorgungsspannungsschwankungen unabhängig wird.

Die Funktionsweise eines erfindungsgemäßen Signalpegelwandlers beruht darauf, daß bei leitendem Transistor T13 und gesperrtem Transistor T14, im folgenden mit Transparentbetrieb bezeichnet, das gleiche Verhalten wie der bekannte ECL-TTL-Signal pegelwandler zeigt. Im umgekehrten Fall, also bei gesperrtem Transistor T13 und leitendem Transistor T14, im nachfolgenden mit Speicherbetrieb bezeichnet, wird das zum Umschaltzeitpunkt an den Kollektoren der Transistoren T1 und T2 auftretende Signal durch die sich gegenseitig verriegelnden Transistoren T11 und T12 aufrechterhalten. Das Umschalten von Transparentbetrieb auf Speicherbetrieb und umgekehrt erfolgt mittels der zueinander komplementären Steuersignale C,C̄. Je nach Betriebsfall wird also entweder das erste Transistorpaar mit den Transistoren T1 und T2 oder das dritte Transistorpaar mit den Transistoren T11 und T12 auf die Stromeinprägung aufgeschaltet. Daraus ergibt sich gegenüber dem Stand der Technik zum einen der Vorteil, daß die Stromaufnahme des erfindungsgemäßen Signalpegelwandlers für beide Betriebsfälle gleich ist, sich also durch die zusätzliche Speicherfunktion nicht erhöht, und zum anderen, daß die Laufzeit trotz der zusätzlichen Speicherfunktion nicht zunimmt. Durch die Transistoren T15 und T16 wird schließlich erreicht, daß das Kollektorpotential der Transistoren T1,T2,T11 und T12 den Wert des Bezugspotentials GND in keinem Fall überschreitet. Abschließend sei darauf hingewiesen, daß als Steuersignale C,C̄ bzw. als ECL-Eingangssignale E,Ē nicht nur symmetrische Signale verwendet werden können, sondern auch unsymmetrische, indem statt komplementärer Signale Ē,C̄ jeweils feste Referenzpotentiale angelegt werden.

## Ansprüche

1. ECL-TTL-Signalpegelwandler mit einem durch ECL-Signale (E, Ē) gesteuerten ersten Transistorpaar (T1,T2), an dessen Kollektoren über jeweils einen Kollektorwiderstand (R1,R2) ein erstes Versorgungspotential (VCC) und an dessen gekoppelte Emitter über eine gemeinsame Stromeinprägung (T5,R3) ein zweites Versorgungspotential (VEE) angelegt ist, und mit einer an die Kollektoren des ersten Transistorpaares (T1,T2) angeschlossenen Gegentaktausgangsstufe (T3,T4,R13) zur AusGabe eines TTL-Signals,
**gekennzeichnet durch**
ein zwischen das erste Transistorpaar (T1,T2) und die Kollektorwiderstände (R1,R2) geschaltetes zweites transistorpaar (T15, T16), an dessen gekoppelten Basen ein Bezugspotential (GND) angelegt ist, dessen Kollektoren jeweils mit einem der Kollektorwiderstände (R1,R2) und dessen Emitter jeweils mit einem der Kollektoren des ersten Transistorpaares (T1,T2) verbunden sind, durch ein emittergekoppeltes drittes Transistorpaar (T11,T12), bei dem die Basis eines Transistors (T11) und der Kollektor des anderen Transistors (T12) mit dem Kollektor eines Transistors (T2) des ersten Transistorpaares (T1,T2) verbunden sind und bei dem der Kollektor des einen Transistors (T11) und die Basis des anderen Transistors (T12) mit dem Kollektor des anderen Transistors (T1) des ersten Transistorpaares (T1,T2) verbunden sind, und
durch ein zwischen erstes Transistorpaar (T1,T2) und Stromeinprägung (T5,R3) geschaltetes, durch Steuersignale (C,C̄) gesteuertes viertes Transistorpaar (T13,T14), bei dem die gekoppelten Emitter mit der Stromeinprägung (T5,R3) verbunden sina und bei der der Kollektor eines Transistors (T13) an die gekoppelten Emitter des ersten Transistorpaares (T1,T2) und der Kollektor des anderen Transistors (T14) an die gekoppelten Emitter des dritten Transistorpaares (T11,T12) angeschlossen sind.

2. ECL-TTL-Signalpegelwandler nach Anspruch 1,
**dadurch gekennzeichnet,**
daß den Emittern des zweiten Transistorpaares (T15,T16) Emitterwiderstände (R11,R12) vorgeschaltet sind.

3. ECL-TTL-Signalpegelwandler nach Anspruch 1 oder 2,
**dadurch gekennzeichnet,**
daß als Stromeinprägung ein erster Transistor (T5) vorgesehen ist, dessen Kollektor mit den gekoppelten Emittern des vierten Transistorpaares (T13,T14) verbunden ist, an dessen Emitter und Basis über einen ersten bzw. zweiten Widerstand (R3,R4) das zweite Versorgungspotential (VEE) angelegt ist und dessen Basis mit dem Emitter eines kollektorseitig mit dem Bezugspotential (GND) beaufschlagten zweiten Transistors (T6) verschaltet ist,

daß an die Basis des zweiten Transistors (T6) über einen dritten Widerstand (R7) das erste Versorgungspotential (VCC) und zum einen über zwei Dioden (D1,D2) und einen vierten Widerstand (R6) in Reihe und zum anderen über die Kollektor-Emitter-Strecke eines dritten Transistors (T7) und einen fünften Widerstand (R8) in Reihe das zweite Versorgungspotential (VEE) angelegt ist, daß an die Basis des dritten Transistors über eine Serienschaltung aus y Dioden (D3,D4,D5) und einem sechsten Widerstand (R9) das Bezugspotential (GND) und über eine Serienschaltung von z Dioden (D6,D7) und einem siebten Widerstand (R10) das zweite Versorgungspotential (VEE) angelegt ist, und

daß das Produkt aus dem dritten Widerstand (R7) und dem siebten Widerstand (R10) gleich dem Produkt aus dem fünften Widerstand (R8) und aus der Summe des sechsten und siebten Widerstandes (R9,R10) ist.

4. ECL-TTL-Signalpegelwandler nach einem der Ansprüche 1 bis 3,

**dadurch gekennzeichnet,**

daß in Serie mit dem sechsten Widerstand (R9) y = drei Dioden (D3,D4,D5) und in Serie mit dem siebten Widerstand (R10) z = zwei Dioden (D6,D7) angeordnet sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | DE-C-3 243 706  (SIEMENS)<br>* Zusammenfassung & Figur; Spalte 2, Zeilen 37-46; Spalte 4, Zeilen 41-56; Spalte 5, Zeilen 1-6 *<br>--- | 1,3,4 | H 03 K  19/018<br>H 03 K   3/288 |
| A | EP-A-0 099 956  (IBM)<br>* Seite 14, Zeilen 31-34; Figur 6 *<br>--- | 1,2 | |
| A | DE-A-3 242 234  (HITACHI)<br>* Zusammenfassung & Figur *<br>----- | 1 | |

**RECHERCHIERTE SACHGEBIETE (Int. Cl.5)**

H 03 K  19
H 03 K   3
H 03 K  19

Der vorliegende Recherchenbericht wurde für alle Patentansprüche erstellt

| Recherchenort | Abschlußdatum der Recherche | Prüfer |
|---|---|---|
| DEN HAAG | 13-03-1990 | DE LA PINTA BALLESTEROS |